(19)

**Europäisches Patentamt**

**European Patent Office**

**Office européen des brevets**

(11) **EP 4 503 352 B1**

(12) **EUROPEAN PATENT SPECIFICATION**

(45) Date of publication and mention
of the grant of the patent:
**04.03.2026 Bulletin 2026/10**

(21) Application number: **24192069.3**

(22) Date of filing: **31.07.2024**

(51) International Patent Classification (IPC):
*H01S 5/065* (2006.01)    *H01S 5/10* (2021.01)
*H01S 5/22* (2006.01)    *H01S 5/227* (2006.01)
*H01S 5/024* (2006.01)    *H01S 5/14* (2006.01)
*H01S 5/34* (2006.01)    *H01S 5/50* (2006.01)
*H01S 5/028* (2006.01)

(52) Cooperative Patent Classification (CPC):
**H01S 5/1064; H01S 5/1014; H01S 5/22;**
**H01S 5/227;** H01S 5/02461; H01S 5/0287;
H01S 5/141; H01S 5/3401; H01S 5/50;
H01S 2301/166; H01S 2301/176

(54) **MODE SUPPRESSED GAIN MEDIUM**

**MODUSUNTERDRÜCKTES VERSTÄRKUNGSMEDIUM**

**MILIEU DE GAIN À MODE SUPPRIME**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **04.08.2023 US 202363517697 P**
**15.12.2023 US 202363610550 P**
**14.06.2024 US 202418743903**

(43) Date of publication of application:
**05.02.2025 Bulletin 2025/06**

(73) Proprietor: **Daylight Solutions Inc.**
**San Diego, CA 92127 (US)**

(72) Inventors:
• **EARLES, Thomas Lester**
**Verona (US)**
• **KLAUS, Michael Alan**
**Cottage Grove (US)**
• **KNIPFER, Benjamin Bryon**
**Sun Prairie (US)**

(74) Representative: **Viering, Jentschura & Partner**
**mbB**
**Patent- und Rechtsanwälte**
**Am Brauhaus 8**
**01099 Dresden (DE)**

(56) References cited:
**US-A- 4 689 797**    **US-A1- 2003 112 842**
**US-A1- 2014 064 311**    **US-A1- 2015 311 676**
**US-A1- 2021 013 701**    **US-A1- 2022 320 826**
**US-B2- 8 811 447**

• **SIGOGNE D ET AL: "1.55 MUM POLARISATION**
**INSENSITIVE INGAASP STRAINED MQW**
**OPTICAL AMPLIFIER INTEGRATED WITH**
**SHORT SPOT-SIZE CONVERTERS",**
**ELECTRONICS LETTERS, THE INSTITUTION OF**
**ENGINEERING AND TECHNOLOGY, GB, vol. 32,**
**no. 15, 18 July 1996 (1996-07-18), pages 1403 -**
**1405, XP000625450, ISSN: 0013-5194, DOI:**
**10.1049/EL:19960904**

**Description**

<u>FIELD</u>

The disclosure relates to a quantum cascade, and in particular to a gain medium, and a method for manufacturing an amplifier.

<u>BACKGROUND</u>

Examples of known laser applications are known from US 2022/320826 A1, SIGOGNE, D. et al.: "1.55 MUM POLARISATION INSENSITIVE INGAASP STRAINED MQW OPTICAL AMPLIFIER INTEGRATED WITH SHORT SPOT-SIZE ADD. CONVERTERS", ELECTRONICS LETTERS, THE INSTITUTION OF ENGINEERING AND TECHNOLOGY, GB, vol. 32, no. 15, (1996-07-18), pages 1403-1405; US 2021/013701 A1 (disclosing a quantum cascade laser); US 2003/112842 A1, US 2014/064311 A1, US 2015/311676 A1, US 8 811 447 B2, and US 4 689 797 A. For many applications, Quantum Cascade lasers ("QCLs") need to be operated at high power, while still maintaining beam quality and pointing stability. The highest power QCLs are generally designed with waveguides wider than cutoff, so they can support a higher order optical mode. Consequently, the beam becomes less stable at high drive levels resulting in broadening of the mode or beam steering. Greater stability can be obtained by narrowing the waveguide, but this reduces the active region area and, correspondingly, the maximum power.

Manufacturers are always searching for ways to improve the power, the beam quality, and the pointing stability of a light source.

<u>SUMMARY OF THE DISCLOSURE</u>

The invention is set in the appended set of claims. One implementation of the invention as defined in claim 1 relates to a gain medium that generates light when sufficiently powered, and that includes a substrate and an active region coupled to the substrate that generates light when sufficient power is directed to the active region. In this design, the active region including (i) a central section having a central dimension along a first axis that is substantially constant along the central section; (ii) a first end section having a first end dimension along the first axis that is substantially constant along the first end section, the first end dimension being smaller than the central dimension; and (iii) a first tapered section that connects the first end section to the central section. The first tapered section has a first tapered dimension along the first axis that tapers from the central section to the first end section.

As an overview, the gain medium is uniquely designed to produce increased power in the laser beam, while maintaining stable beam quality and pointing stability of the laser beam. The unique design of the gain medium also minimizes internal reflections so this design can be applied to amplifiers and external cavity lasers without penalty.

The active region is a quantum cascade active region.

The first end section may include a first facet, and the active region emits light from the first facet.

As provided herein, the first tapered section can have an adiabatic taper. The transition between the straight sections and tapered sections is made adiabatic by smoothing the transition by using a smooth, curved transition such as for example a spline, which is a smooth curve that passes through or near a set of fit points.

Additionally, the gain medium can include (i) a second end section having a second end dimension along the first axis that is substantially constant along the second end section, the second end dimension being smaller than the central dimension; and (ii) a second tapered section that connects the second end section to the central section. In this implementation, the second tapered section has a second tapered dimension along the first axis that tapers from the central section to the second end section. Moreover, the second end dimension can be approximately equal to the first end dimension. Further, the second end section can include a second facet that is spaced apart from the first facet. In certain designs, the active region emits light from the second facet.

The active region is (i) a quantum cascade active region, and the active region can additionally include one or more of the following: (ii) the first end section includes a first facet, and wherein the active region emits light from the first facet; (iii) the first tapered section has an adiabatic taper; (iv) the first tapered section has a tapered length of at least seven microns; (iv) a second end section having a second end dimension along the first axis that is substantially constant along the second end section, the second end dimension being smaller than the central dimension; (iv) a second tapered section that connects the second end section to the central section, wherein the second tapered section has a second tapered dimension along the first axis that tapers from the central section to the second end section; and/or (v) a second facet that is spaced apart from the first facet, and wherein the active region emits light from the second facet.

In yet another implementation, as defined in claim 9, a method for making a gain medium includes providing a substrate, and growing an active region on the substrate. The active region including (i) a central section having a central dimension along a first axis that is substantially constant along the central section; (ii) a first end section having a first end dimension along the first axis that is substantially constant along the first end section, the first end dimension being smaller than the central dimension; and (iii) a first tapered section that connects the first end section to the central section. In this design, the first tapered section has a first tapered dimension along the first axis that tapers from the central section to the first end section.

The gain medium that amplifies a signal when sufficiently powered includes: a substrate; and an active region that amplifies the signal when sufficient power is directed to the active region. In this implementation, the active region includes (i) a central section having a central dimension along a first axis that is substantially constant along the central section; (ii) a first end section having a first end dimension along the first axis that is substantially constant along the first end section, the first end dimension being smaller than the central dimension; and (iii) a first tapered section that connects the first end section to the central section. The first tapered section has a first tapered dimension along the first axis that tapers from the central section to the first end section.

## BRIEF DESCRIPTION OF THE DRAWINGS

The novel features of this invention, as well as the invention itself, both as to its structure and its operation, will be best understood from the accompanying drawings, taken in conjunction with the accompanying description, in which similar reference characters refer to similar parts, and in which:

Figure 1A is a simplified perspective view of a laser assembly having a ridge guide configuration;

Figure 1B is a cut-away view taken on line 1B-1B in Figure 1A;

Figure 1C is a cut-away view taken on line 1C-1C in Figure 1A;

Figure 1D is a cut-away view taken on line 1D-1D in Figure 1A;

Figure 1E is a simplified, enlarged, top view of an active region from the laser assembly of Figure 1A;

Figure 2A is a simplified perspective view of another implementation of a laser assembly having a ridge guide configuration;

Figure 2B is a simplified, enlarged, top view of an active region from the laser assembly of Figure 2A;

Figure 3A is a simplified perspective view of a laser assembly having a buried heterostructure configuration;

Figure 3B is a cut-away view taken on line 3B-3B in Figure 3A;

Figure 3C is a cut-away view taken on line 3C-3C in Figure 3A;

Figure 3D is a cut-away view taken on line 3D-3D in Figure 3A;

Figure 4 is a simplified perspective view of an external cavity laser assembly;

Figure 5 is a simplified perspective of a laser assembly including an amplifier;

Figure 6A is a simplified perspective view of an amplifier having a ridge guide configuration;

Figure 6B is a simplified, enlarged, top view of an active region from the amplifier of Figure 6A;

Figure 7A is a simplified perspective view of another implementation of an amplifier having a buried heterostructure configuration;

Figure 7B is a simplified, enlarged, top view of an active region from the amplifier of Figure 7A;

Figure 8A is a simplified perspective view of another implementation of a laser assembly having a buried heterostructure configuration;

Figure 8B is a cut-away view taken on line 8B-8B in Figure 8A;

Figure 8C is a cut-away view taken on line 8C-8C in Figure 8A; and

Figure 8D is a cut-away view taken on line 8D-8D in Figure 8A.

## DESCRIPTION

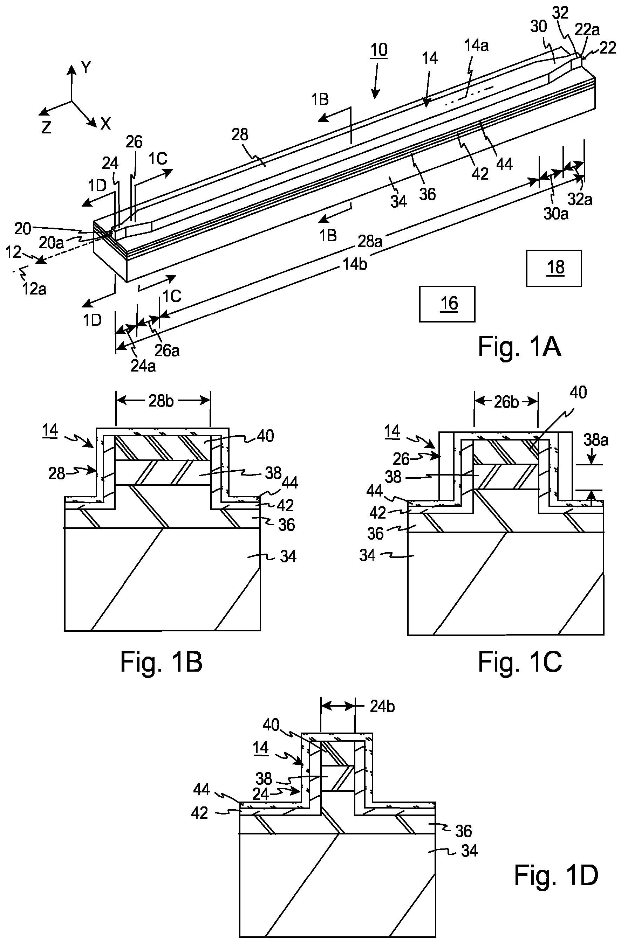

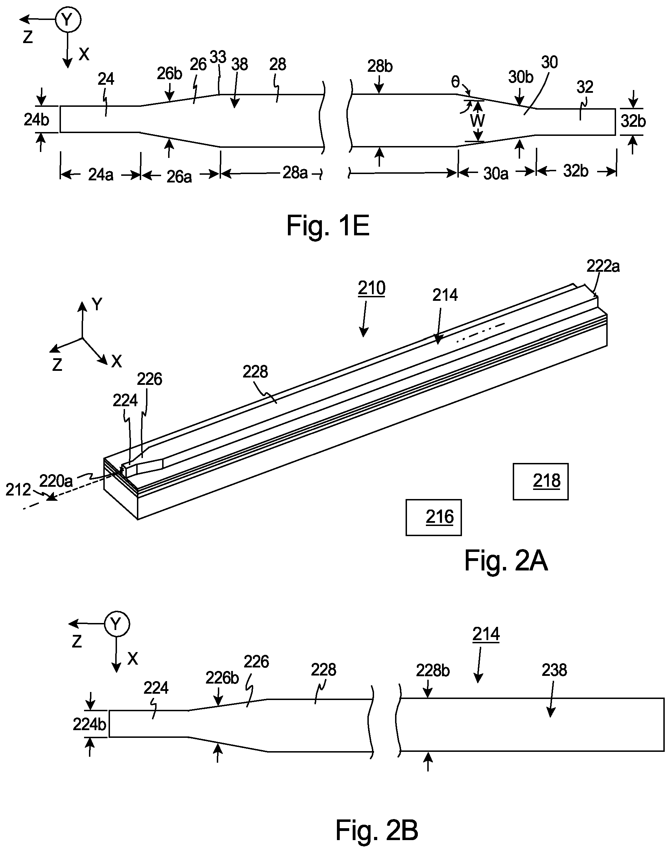

Figure 1A is a simplified, perspective view of a laser assembly 10 that generates a laser beam 12 (illustrated as a dashed arrow) along a beam axis 12a. In certain implementations, the laser assembly 10 includes a gain medium 14, a power supply 16 (illustrated as a box) that directs power to the gain medium 14 to generate the laser beam 12, and a system controller 18 (illustrated as a box) that selectively controls the power to the gain medium 14. The design of each of the components of the laser assembly 10 can be varied to change the performance of the laser assembly 10. Moreover, the laser assembly 10 can be designed to include more components than are illustrated in Figure 1. For example, the laser assembly 10 can be designed to include a wavelength selective element that forms an external cavity for selectively tuning the wavelength of the laser beam 12.

As an overview, the gain medium 14 is uniquely designed to produce increased power in the laser beam 12, while maintaining stable beam quality and pointing stability of the laser beam 12. The unique design of the gain medium 14 also minimizes internal reflections so this design can be applied to amplifiers and external cavity lasers without penalty. In Figure 1A, the gain medium 14 is used as a laser. Alternatively, the gain medium 14 can be used as an amplifier.

Some of the Figures provided herein include an orientation system that designates an X axis, a Y axis, and a Z axis. It should be understood that the orientation system is merely for reference and can be varied. Moreover, these axes can alternatively be referred to as a first, second, or third axis.

The laser assembly 10 in Figure 1A and the other Figures can be used in a variety of applications, such as laser pointing, testing, measuring, diagnostics, pollution monitoring, leak detection, security, pointer tracking, jamming a guidance system, analytical instruments, infrared microscopes, imaging systems, homeland security and industrial process control, and/or a free space communication system. It should be noted that this is a non-exclusive list of possible applications.

In the non-exclusive implementation of Figure 1A, the gain medium 14 has a medium axis 14a (along the Z axis), and the gain medium 14 includes a first end 20 having a first facet 20a, and a second end 22 having a second facet 22a that is opposite to and spaced apart from the first facet 20a along the medium axis 14a. With the present arrangement, current from the power supply 16 flowing through the gain medium 14 generates the laser beam 12 that is emitted from one or both facets 20a, 22a (depending upon the design).

In one embodiment, the gain medium 14 is a broadband emitter that emits from both facets 20a, 22a. Alternatively, both facets 20a, 22a of the gain medium 14 can be coated with a reflective coating to form a Fabry-Perot laser. Still alternatively, a wavelength selective element (not shown in Figure 1A) can be incorporated into the gain medium 14. In a different example, the laser assembly 10 can include an external wavelength selective element (not shown in Figure 1A) that allows the wavelength of the laser beam 12 to be selectively tuned.

In a specific example, the gain medium 14 can be designed to only emit from the first facet 20a. In this implementation, the first facet 20a is coated with a reflective coating, and the second facet 22a is coated with a highly reflective coating. With the reflective coating on the first facet 20a, a portion of the light directed at the first facet 20a is reflected back into the gain medium 14 and a portion of the light directed at the first facet 20a is transmitted through the first facet 20a. Further, with the highly reflective coating on the second facet 22a, the bulk of the light directed at the second facet 22a is reflected back into the gain medium 14. Alternatively, the facets 20a, 22a can be coated so that light emits from both facets 20a, 22a.

In Figure 1A, the laser beam 12 is illustrated as being launched into free space. Alternatively, for example, the laser assembly 10 can be designed to include an optical fiber (not shown in Figure 1A), and the laser beam 12 can be fiber coupled.

As provided herein, in certain implementations, the gain medium 14 can be separated into five sections along the medium axis 14a. More specifically, in Figure 1A, moving left to right along the medium axis 14a, the five sections can be designated as (i) a first end section 24 that includes the first facet 20a; (ii) a first tapered section 26; (iii) a central section 28; (iv) a second tapered section 30; and (v) a second end section 32 that includes the second facet 22a. It should be noted that the gain medium 14 is physically not separated, and that the width of the gain medium 14 changes along the medium axis 14a. More specifically, in this design, (i) the end sections 24, 32 are relatively narrow; (ii) the central section 28 is relatively wide; (iii) the end sections 24, 32 are narrower than the central section 28; (iv) the first tapered section 26 connects the first end section 24 to the central section 28; and (v) the second tapered section 30 connects the central section 28 to the second end section 32.

Further, in certain implementations, one or both tapered sections 26, 30 has an adiabatic taper. As provided herein, the term "adiabatic taper" shall mean a taper that varies in width with position such that the change does not introduce internal reflections and enables efficient coupling of the fundamental mode between (i) the first end section 24 and the central section 28, and (ii) the second end section 32 and the central section 28. The adiabatic taper is designed to allow the fundamental mode of the gain medium 14 to travel between the end sections 24, 28 without change, while stripping any higher order modes. The amount of taper necessary to achieve an adiabatic taper will vary as a function of wavelength of the laser beam 12, as well as the waveguide width, and effective index. As a non-exclusive example, each tapered section 26, 30 can have a tapered length of greater than approximately 20 microns with an emission wavelength of approximately 4.6 μm when the central section 28 is approximately 5.0 microns wide and the end sections 32 and 24 are approximately 3.5 microns wide.

The adiabatic nature of the taper sections 26, 30 allows for efficient coupling of light between the wide central section 28 and the narrow end sections 24, 32, without reflections. This allows for the active area scaling of single-spatial mode devices for uses in semiconductor light emitters including, amplifiers, distributed feedback lasers (DFBs), Fabry Perot lasers, and external cavity lasers, among others.

With the present design, (i) the central section 28 can be sized to support multiple spatial modes; (ii) the narrow, end sections 24, 32 can be sized to support a single spatial mode; and (ii) the tapered sections 26, 20 are sized and shaped to act as mode strippers that eliminate higher order guided modes generated by the central section 28. Generally, single mode laser modules offer the best beam characteristics, while multimode laser modules offer higher output power, but the beam (typically elliptical) characteristics are not as good.

As provided herein, the gain medium 14 utilizes the wide central section 28 (with larger active region) to generate higher power, and the tapered sections 26, 30 to direct the light to the narrow, end sections 24, 32 that support only one guided optical mode. As a result, the gain medium 14 can generate higher power, without degradation in beam quality.

Stated in another fashion, the gain medium 14 is designed with the adiabatically taper from narrow to wide sections to minimize waveguide loss while maintaining single-mode beam qualities. The central section 28, without the addition of the narrow sections 24, 32, would typically support higher order modes, however, the incorporation of the narrow sections 24, 32 strips higher order modes. Additionally, the invention not only results in an improvement in beam properties, but also in peak powers and efficiencies under continuous wave operation relative to its straight, wide guide counterpart. This may be attributed to better heat extraction from the narrower cores at the end sections 24, 32, which leads to reduced heating at the facets 20a, 22a. Similarly, the reduction in heat at the facets 20a, 22a may increase overall device reliability, and device coating reliability.

Novel features of the gain medium 14 include, but are not limited to, (i) the adiabatic taper in the tapered sections 26, 30 between the narrow end sections 24, 32, and the wide central section 28 allows for the efficient, low loss, transition between the sections 24, 28, 32 with no internal reflections; (ii) the use of the narrower end sections 24, 32 results in devices with improved CW efficiency and peak power relative to its straight, wide counterpart; and (iii) the implementation of smoothed transitions 33 between the taper and straight sections 24, 26, 28, 30, 32. One or more (e.g., all) of the transitions 33 use a smooth, curved transition such as for example a spline, which is a smooth curve that passes through or near a set of fit points.

The design of the gain medium 14 can be varied to achieve the performance requirements of the gain medium. As a non-exclusive example, a suitable gain medium 14 can have (i) a medium length 14b (from the first facet 20a to the second facet 22a) of between approximately 0.5 and fifteen millimeters. Stated differently, in alternative, non-exclusive implementations, the gain medium 14 can have a medium length 14b of at least 0.5, 1, 2, 3, 4, 5, 6, 7, 8, 9, 10, 11, 12, 13, 14, 15, or more millimeters. However, other values are possible.

In one non-exclusive implementation, (i) the first end section 24 has a first end length 24a of between approximately fifty microns to three millimeters; (ii) the first tapered section 26 has a first tapered length 26a (measured parallel to the medium axis 14a) of between approximately twenty microns to one millimeter; (iii) the central section 28 has a central length 28a of between approximately five hundred microns to fifteen millimeters; (iv) the second tapered section 30 has a second tapered length 30a (measured parallel to the medium axis 14a) of between approximately twenty microns to one millimeter; and (v) the second end section 32 has a second end length 32a of between approximately fifty microns to three millimeters. In one non-exclusive example, the (i) the first end length 24a is approximately 150 microns; (ii) the first tapered length 26a is approximately 150 microns; (iii) the central length 28a is approximately 900 microns; (iv) the second tapered length 30a is approximately 150 microns; and (v) the second end length 32a is approximately 150 microns.

The size, shape, and materials utilized in the gain medium 14 can be varied to achieve the desired characteristics of the gain medium 14. In accordance with the claimed invention, the gain medium 14 is a Quantum Cascade ("QC") gain medium that may generate the laser beam 12 that is in the mid-infrared ("MIR") range. In an alternative, example not in accordance with the claimed invention, the gain medium 14 can be an Interband Cascade ("IC") gain media. An Interband Cascade gain medium is a hybrid between laser diodes having a direct bandgap and Quantum Cascade gain media.

The power supply 16 is electrically connected to and directs power to the gain medium 14. In one embodiment, the power supply 16 directs current to the gain medium 14 in a pulsed fashion. Alternatively, the power supply 16 can direct current to the gain medium 14 in a continuous fashion. The power supply 16 can be a generator, a battery, the electrical grid, or another power source.

The system controller 18 selectively controls the components of the laser assembly 10. The system controller 18 can include one or more processors that are used to control the current flow to the gain medium 16.

It should be noted that the components of the laser assembly 10 can be secured to a rigid mount (not shown) such as a test or experimental bench, a frame, a circuit board, or other structure.

Additionally, the laser assembly 10 can include a temperature controller (not shown) that controls the temperature of the gain medium 14.

Figure 1B is a simplified cut-away of the central section 28 of the gain medium 14 taken on line 1B-1B in Figure 1A near the center of the gain medium 14. Figure 1C is a simplified cut-away view of the first tapered section 26 of the gain medium 14 taken on line 1C-1C in Figure 1A. Further, Figure 1D is a simplified cut-away view of the first end section 24 of the gain medium 14 taken on line 1D-1D in Figure 1A.

With reference to Figures 1A-1D, the gain medium 14 includes a number of layers, namely (i) a substrate layer 34 (also referred to as the "substrate"), (ii) a first cladding layer 36, (iii) a core layer 38 (as referred to as the "active region"), (iv) a second cladding layer 40, (v) a current blocking layer 42, and (vi) a conductive layer 44. The thickness and shape of these layers can be varied to suit the design of the gain medium 14. Further, one or more of the layers can have a different configuration than is illustrated in Figures 1B-1D.

It should be noted that in certain implementations, each layer 34, 36, 38, 40, 42, 44 extends the entire length of the gain medium 14 between the ends 20, 22. With this design, each section 24, 26, 28, 30, 32 includes a portion of each layer 34, 36, 38, 40, 42, 44.

In certain embodiments, the power supply 16 (illustrated in Figure 1A) is electrically connected to the conductive layer 44 and the substrate layer 34. With this design, current from the power supply 16 is directed through the core layer 38 to generate the laser beam 12.

The substrate layer 34 is typically the thickest part of the gain medium 14 and, as non-exclusive examples, can be made of n-doped indium phosphide ("InP") or gallium antimonide ("GaSb"). In Figures 1A-1D, the substrate layer 34 is at the bottom, is generally rectangular shaped, and can have a thickness of between approximately 100 and 200 microns.

The first cladding layer 36 is positioned between the substrate layer 34 and the core layer 38, and the second cladding layer 40 is positioned on the top of the core layer 38. With this design, the core layer 38 is positioned between the first cladding layer 36 and the second cladding layer 40. The cladding layers 36, 40 have a lower refractive index than the core layer 38. As a result thereof, the cladding layers 36, 40 refract light back into the core layer 38 and act as a waveguide. In one embodiment, each cladding layer 36, 40, or portions thereof, can be made from n-doped InP. In certain embodiments, the cladding layers 36, 40 have a relatively high coefficient of thermal conductivity (approximately ~ 60 W/m/K). This will help to spread heat from the core layer 38.

The core layer 38 is the active region of the gain medium 14, defines the two facets 20a, 22a, and in certain implementations includes a periodic series of thin layers of varying material composition forming a superlattice. The superlattice introduces a varying electric potential across the core layer 38 meaning that there is a varying probability of electrons occupying different positions over the length of the gain medium 14.

In one embodiment, for QC gain medium 14, the core layer 38 is a QC core layer that can utilize two different semiconductor materials, such as Indium gallium arsenide ("InGaAs") and Aluminium indium arsenide ("AlInAs") to form a series of potential wells and barriers for electron transitions. With this design, the output wavelength of the gain medium 14 can be changed by changing the thicknesses and compositions of the periodic layers.

In another example not in accordance with the claimed invention, for an IC gain medium, the core layer 38 is an IC core layer that can utilize Gallium Antimonide (GaSb), Aluminum Indium Arsenide (AlInAs), Gallium Indium Arsenide (GaInAs), Indium Arsenide (InAs), and Aluminum Antimonide (AlSb).

In one non-exclusive implementation, the core layer 38 has a core thickness 38a (referenced in Figure 1C) of between approximately one to two microns. However, other values are possible.

In the embodiment illustrated in Figures 1B-1D, the current blocking layer 42 is deposited on the sides of the core layer 38 to guide the current injected into the core layer 38 and guide the light generated by the core layer 38 to the facets 20a, 22a. The current blocking layer 42 can also be referred to as a dielectric layer. As a non-exclusive example, the current blocking layer 42 can be an undoped or semi-insulating cladding layer and can be made of Indium Phosphide (InP).

In certain implementations, the conductive layer 44 coats the second cladding layer 40 and the current blocking layer 42 and provides an electrical contact for the power supply 16. Further, the conductive layer 44 assists in removing heat created when producing light. For example, the conductive layer 44 can be an electrically conductive material, such as gold or a multilayer stack of conductive materials like titanium, platinum and gold.

As provided above, the gain medium 12 is uniquely designed so that less current is directed through the end sections 24, 32 than the central section 28. As a result thereof and as these sections get narrower the heat is more efficiently removed from section 38, the temperature at the facets 20a, 22a will be less, and this will reduce thermal and physical stress on the coatings on the facets 20a, 22a. This will also reduce the likelihood of failure of one or both of the facets 20a, 22a.

Figure 1E is a simplified, enlarged top view of a suitable core layer 38. With reference to Figures 1B-1E, (i) the first end section 24 has a first end dimension 24b (illustrated in Figure 1D and 1E) measured along the X axis, that is substantially constant along the first end section 24; (ii) the first tapered section 26 has a first tapered dimension 26b (illustrated in Figure 1C and Figure 1E) measured along the X axis; (iii) the central section 28 has a central dimension 28b measured along the X axis (illustrated in Figure 1B and Figure 1E); (iv) the second tapered section 30 has a second tapered dimension 30b (illustrated in Figure 1E) measured along the X axis; and (v) the second end section 32 has a second end dimension 32b (illustrated in Figure 1E) measured along the X axis.

For ease of discussion, (i) the first end dimension 24b can alternatively be referred to as the first end width; (ii) the first tapered dimension 26b can alternatively be referred to as the first tapered width; (iii) the central dimension 28b can alternatively be referred to as the central width; (iv) the second tapered dimension 30b can alternatively be referred to as the second tapered width; and (v) the second end dimension 32b can alternatively be referred to as the second end width.

More specifically, in one, non-exclusive implementation, (i) the first end width 24b is equal to the second end width 32b; (ii) the central width 28b is greater than the end widths 24b, 32b; (iii) the first tapered width 26b varies along the first tapered section 26; and (iv) the second tapered width 30b varies along the second tapered section 30. As alternative, non-exclusive examples, the central width 28b can be at least 2, 5, 10, 15, 20, 30, 40, 50, 60, 70, 80, 100 or more percent greater than the first end width 24b and/or the second end width 32b.

In one implementation, (i) the value of the first end width 24b is selected to support only a single, fundamental, lateral mode; (ii) the value of the second end width 32b is selected to support only a single, fundamental, lateral mode; (iii) the value of the central width 28b is selected to support multiple, lateral modes; (iv) the taper of the first tapered section 26 is adiabatic so that the first tapered section 26 acts as a mode stripper that eliminates higher order guided modes generated by the central section 28; and (v) the taper of the second tapered section 30 is adiabatic so that the second tapered section 30 acts as a mode stripper that eliminates higher order guided modes generated by the central section 28. As provided above, the adiabatic taper between the wide, central section 28, and the narrow end sections 24, 32 results in no internal reflections, a low loss transition, and potentially, the reduction of heating at the facet (and in turn the potential for higher reliability devices) and high brightness single lateral mode devices.

In one, non-exclusive example, an adiabatic taper can be expressed by equation the following equation 1:

$$\theta < \frac{\lambda_0}{2W\eta_{eff}} \qquad \text{Equation 1}$$

where $\theta$ is a local half angle of the taper at point Z; $\lambda_0$ is the emission wavelength; W is the width at the measurement of the local half angle; and $\eta_{eff}$ is the effective index. In another implementation, the taper can have a value of up to 1.4 times the local half angle determined by Equation 1. The effective index varies by wavelength, and with each different core design. Table 1 below provides non-exclusive examples of effective index, wavelength, width, and local half angle. In general, an increase in effective index is expected with a longer wavelength. However, effective index also varies with the core design.

Table 1

| Wavelength (μm) | $n_{eff}$ | W (μm) | Theta (Radians) | Theta (Degrees) |
|---|---|---|---|---|
| 3.8 | 3.16 | 4.5 | 0.13 | 7.67 |
| 4 | 3.14 | 4.5 | 0.14 | 8.12 |
| 4.6 | 3.16 | 4.5 | 0.16 | 9.26 |
| 8 | 3.19 | 8 | 0.16 | 8.98 |

In one non-exclusive implementation, (i) the first end width 24b is between approximately 2.5 to 8 microns; (ii) the second end width 32b is between approximately 2.5 to 8 microns; (iii) the central width 28b between approximately 4.5 to 15 microns; (iv) the first tapered length 26a is between approximately 20 microns and 1 millimeter, and the local half angle of the taper follows Equation 1; and (v) the second tapered length 30a is between approximately 20 microns and 1 millimeter, and the local half angle of the taper follows Equation 1. In one, non-exclusive example, (i) the first end width 24b is approximately 3 microns; (ii) the second end width 32b is approximately 3 microns; (iii) the central width 28b is approximately 4.5 microns; (iv) the first tapered length 26a is approximately 20 microns, and the local half angle of the taper is approximately 5.7 degrees; and (v) the second tapered length 30a is approximately 20 microns, and the local half angle of the taper is approximately 5.7 degrees.

As provided above, in any of the implementations, in addition to the transition 33 between (i) the first end section 24 and the first tapered section 26; also the transitions 33 between (ii) the first tapered section 26 and the central section 28; (iii) the central section 28 and the second tapered section 30; and (iv) the second tapered section 30 and the second end section 32 can be curved to further reduce reflections.

The method utilized to grow the gain medium 14 can be varied according to the type of gain medium 14. In one implementation, one or more gain mediums are grown and patterned on a common wafer.

Figure 2A is a simplified, perspective view of another laser assembly 210 that generates a laser beam 212 that includes a gain medium 214, a power supply 216, and a system controller 218. In this design, the power supply 216, and the system controller 218 are similar to the corresponding components described above. However, in this implementation, the gain medium 214 is slightly different in that it only includes one tapered section. More specifically, in this implementation, the gain medium 214 only includes three sections that can be designated as (i) a first end section 224 that includes the first facet 220a; (ii) a first tapered section 226; and (iii) a central section 228 that includes the second facet 222a. In this example, the first end section 224, the first tapered section 226, and the central section 228 can be similar to the corresponding components described above in reference to Figures 1A-1E. It should be noted that in the design of Figure 2A, the central section 228 is not centrally located, but it is still the principal generator of the power of the laser beam 212.

In one implementation, the second facet 222a includes a highly reflective coating the gain medium 214 only emits from the first facet 220a.

Figure 2B is a simplified, enlarged top view of a suitable core layer 38 for the gain medium 214 of Figure 2A. In this design, (i) the first end section 224 has a first end dimension 224b measured along the X axis, that is substantially constant along the first end section 224; (ii) the first tapered section 226 has a first tapered dimension 226b measured along the X axis; and (iii) the central section 228 has a central dimension 228b measured along the X axis. In this implementation, (i) the central width 228b is greater than the first end width 224b; and (ii) the first tapered width 226b varies along the first tapered section 226.

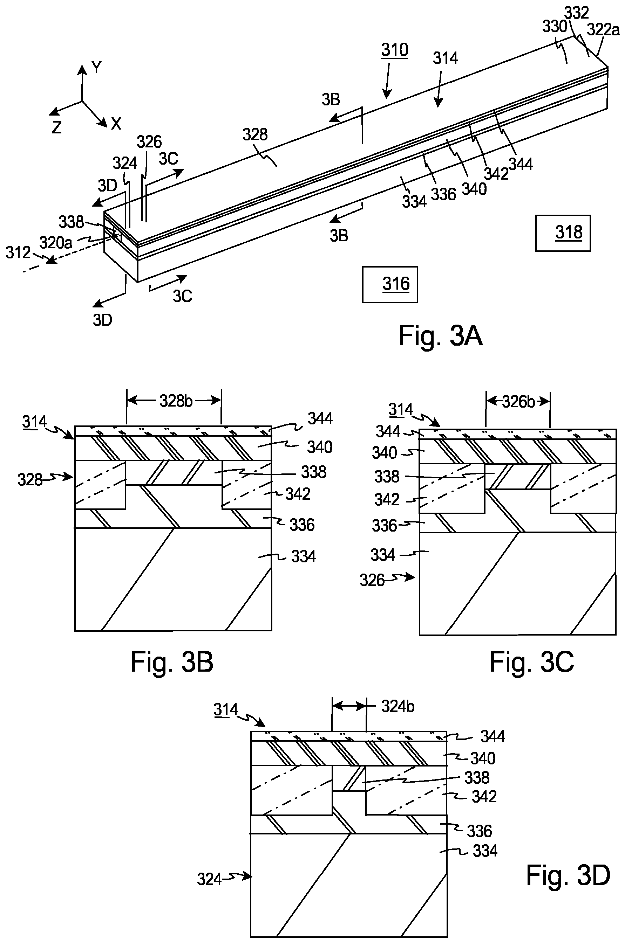

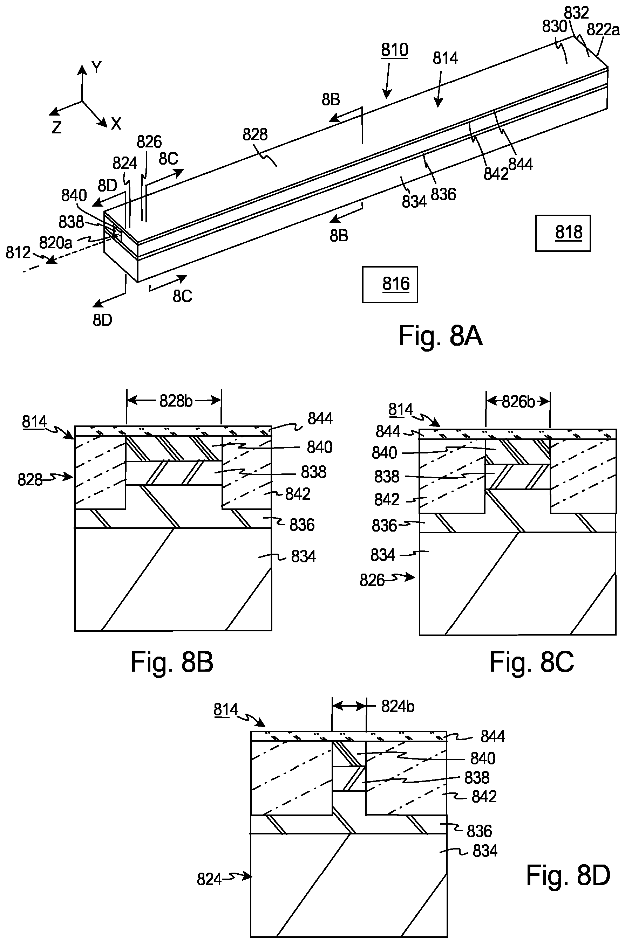

Figure 3A is a simplified, perspective view of yet another laser assembly 310 that generates a laser beam 312 that includes a gain medium 314, a power supply 316, and a system controller 318. In this design, the power supply 316, and the system controller 318 are similar to the corresponding components described above. However, in this implementation, the gain medium 314 is slightly different in that the gain medium 314 was grown with a buried heterostructure. It should be noted that the buried heterostructure of the gain medium 314 of Figure 3A, is just one, non-exclusive example of a two-step regrowth structure, and that other configurations of the buried heterostructure of the gain medium are possible. For example, Figures 8A-8D described below, illustrate another, non-exclusive example of a buried heterostructure.

Similar to implementation illustrated in Figures 1A-1E, the gain medium 314 of Figure 3A can be designed to include five sections that are designated as (i) a first end section 324 that includes the first facet 320a; (ii) a first tapered section 326; (iii) a central section 328; (iv) a second tapered section 330; and (vi) a second end section 324 that includes the second facet 322a. The design of each of those sections 324, 326, 328, 330, 332 can be somewhat similar to the corresponding components described above and illustrated in Figures 1A-1E.

Alternatively, for example, the gain medium 314 of Figure 3A can be designed to include only three sections similar to the design described above and illustrated in Figures 2A and 2B.

Figure 3B is a simplified cut-away of the central section 328 of the gain medium 314 taken on line 3B-3B in Figure 3A near the center of the gain medium 314 that illustrates the central dimension 328b. Figure 3C is a simplified cut-away view of the first tapered section 326 of the gain medium 314 taken on line 3C-3C in Figure 3A that illustrates the first tapered dimension 326b. Further, Figure 3D is a simplified cut-away view of the first end section 324 of the gain medium 314 taken on line 3D-3D in Figure 3A that illustrates the first end dimension 324b. These Figures illustrate the buried heterostructure of the gain medium 314, as well as the varying width of the gain medium 314.

With reference to Figures 3A-3D, the gain medium 314 includes a plurality of layers, namely (i) a substrate layer 334, (ii) a first cladding layer 336, (iii) a core layer 338, (iv) a second cladding layer 340, (v) a current blocking layer 342, and (vi) a conductive layer 344. The thickness and shape of these layers can be varied to suit the design of the gain medium 314. Further, one or more of the layers can have a different configuration than is illustrated in Figures 3A-3D.

In the implementation of Figures 3A-3D, the layers 334, 336, 338, 340, 342, 344 can be similar to the corresponding components described above and illustrated Figures 1A-1E. However, in Figures 3A-3D, the location and configuration of some of the layers 334, 336, 338, 340, 342, 344 is slightly different.

In Figures 3A-3D, (i) the first cladding layer 336 is positioned between the substrate layer 334 and the core layer 338, (ii) the core layer 338 is positioned between the cladding layers 336, 340, (iii) the current blocking layer 342 is positioned on the sides of the core layer 338, and between the cladding layers 336, 340, and (iv) the conductive layer 344 is positioned over the second cladding layer 340.

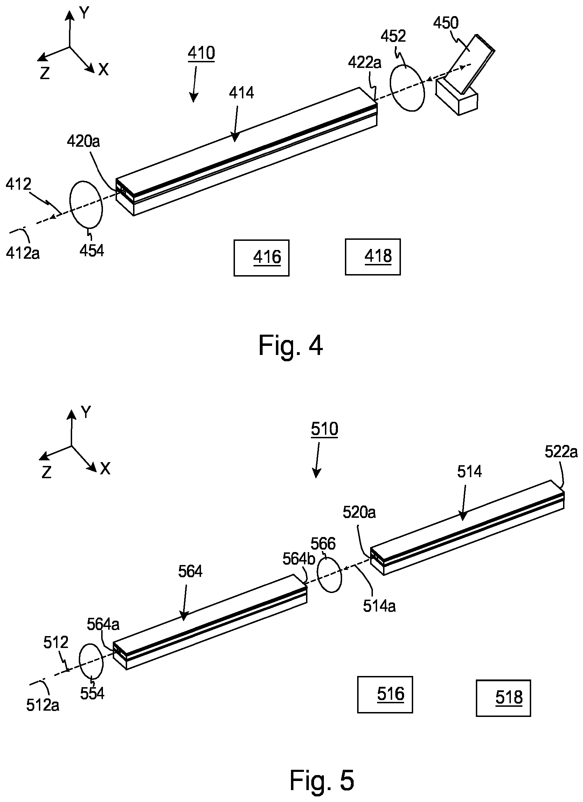

Figure 4 is a simplified perspective view of an external cavity laser assembly 410 that generates a laser beam 412 (illustrated as a dashed arrow) along a beam axis 412a. In this implementation, the laser assembly 410 includes a gain medium 414, a power supply 416, a system controller 418, a wavelength selective ("WS") feedback assembly 450 that can be used to tune the primary wavelength of the laser beam 412, a cavity lens 452, and an output lens 454. In this implementation, the power supply 416 and the system controller 418 can be similar to the corresponding components described above. However, in this implementation, the system controller 418 can be designed to additionally control the WS feedback assembly 450.

In the implementation of Figure 4, the gain medium 414 can be similar to the designs described above in reference to Figures 1A-1E, 2A-2B, 3A-3D. In certain implementations, (i) the gain medium 414 emits from both facets 420a, 422a, (ii) the first facet 420a includes a partly reflective coating to form one end of the external cavity, and (iii) the second facet 422a includes an anti-reflection coating to allow light to easily enter and exit the second facet 422a. In Figure 4, the second facet 422a faces the cavity lens 452 and the WS feedback assembly 450, and (ii) the first facet 420a faces the output lens 454.

The WS feedback assembly 450 reflects light back to the gain medium 414 along a lasing axis (e.g., along the Z axis), and is used to precisely adjust the lasing frequency of the external cavity and the wavelength of the laser beam 412. The design of the WS feedback assembly 450 can vary pursuant to the teachings provided herein. Non-exclusive examples of suitable designs include a diffraction grating, a MEMS grating, prism pairs, a thin film filter stack with a redirector, an acoustic optic modulator, or an electro-optic modulator. The WS feedback assembly 450 can be fixed or adjustable (e.g., a motor that moves a grating).

The cavity lens 452 is positioned between the gain medium 414 and the WS feedback assembly 450 along the lasing axis, and collimates and focuses the light that passes between these components. For example, in one embodiment, the cavity lens 452 can include an aspherical lens having an optical axis that is aligned with the lasing axis.

The output lens 454 collimates and focuses the laser beam 412 that exits the first facet 420a. For example, the output lens 454 can be somewhat similar in design to the cavity lens 452.

Figure 5 is a simplified perspective view of another assembly 510 that generates an output laser beam 512 (illustrated as a dashed arrow) along a beam axis 512a. In this simplified implementation, the assembly 510 includes a first gain medium 514, a second gain medium 564, a power supply 516, a system controller 518, an intermediary lens 566, and an output lens 554. In this implementation, the power supply 516 and the system controller 518 can be similar to the corresponding components described above. However, in this design, the power supply 516 and the system controller 518 can be designed to power and control both of the gain mediums 514, 564.

In the implementation of Figure 5, one or both of the gain mediums 514, 564 can be somewhat similar to the designs described above in reference to Figures 1A-1E, 2A-2B, 3A-3D. As alternative, non-exclusive examples, (i) one or both of the gain mediums 514, 564 can be similar to the design illustrated in Figures 1A-1E; (ii) one or both of the gain mediums 514, 564 can be similar to the design illustrated in Figures 2A-2B; (iii) one or both of the gain mediums 514, 564 can be similar to the design illustrated in Figures 3A-3D; (iv) one the gain mediums 514, 564 can be similar to the design illustrated in Figures 1A-1E, and the other of the gain mediums 514, 564 can be similar to the design illustrated in Figures 2A-2B; (v) one the gain mediums 514, 564 can be similar to the design illustrated in Figures 1A-1E, and the other of the gain mediums 514, 564 can be similar to the design illustrated in Figures 3A-3D; or (vi) one the gain mediums 514, 564 can be similar to the design illustrated in Figures 2A-2B, and the other of the gain mediums 514, 564 can be similar to the design illustrated in Figures 3A-3D.

In one implementation, (i) the first gain medium 514 functions as a laser that generates and emits a signal 514a (e.g., a laser beam) from only the front facet 520a; (ii) the first facet 520a of the first gain medium 514 includes a partly reflective coating to form one end of the external cavity, and (iii) the second facet 522a of the first gain medium 514 includes a highly reflective coating. Alternatively, for example, the laser assembly 510 can be designed to include the WS feedback assembly 450 in Figure 4.

Further, in one implementation, (i) the second gain medium 564 functions as an amplifier that amplifies the signal 514a to generate the output laser beam 512 (also referred to as an "amplified signal"); and (ii) the second gain medium 564 includes a first facet 564a, and a second facet 564b, and both of these facets 564a, 564b are coated with an anti-reflection coating. With this design, the second facet 564b receives the signal 514a, the second gain medium 564 amplifies the signal 514a, and the amplified, output laser beam 512 is emitted from the first facet 564a. In Figure 5, the second facet 564b of the second gain medium 564 faces the intermediary lens 566 and the first gain medium 514, and (ii) the first facet 564a faces the output lens 554.

The intermediary lens, or set of lenses, 566 is positioned between the gain mediums 514, 564, and collimates and focuses the signal 514a directed at the second gain medium 564. For example, in one embodiment, the intermediary lens 566 can include an aspherical lens having an optical axis. The intermediary lens or lenses 566 can collimate and/or focus the signal 514a.

The output lens 554 collimates and focuses the laser beam 512 that exits the second gain medium 564. For example, the output lens 554 can be somewhat similar in design to the intermediary lens 566.

It should be noted that the laser assembly 510 of Figure 5 can include more or fewer components than are illustrated in Figure 5. For example, the laser assembly 510 can be designed to include multiple amplifiers (e.g., multiple, second gain mediums 564) arranged in series.

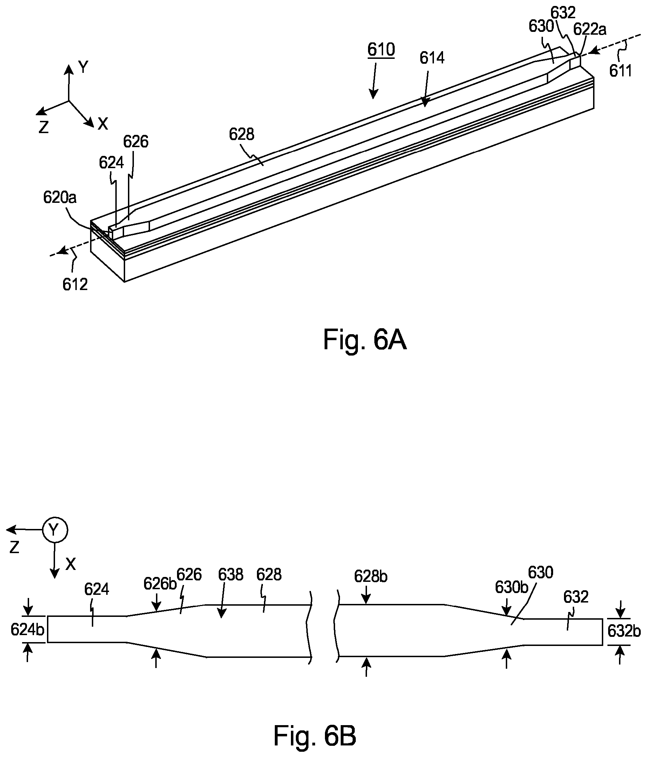

Figure 6A is a simplified perspective view of a gain medium 614 having a ridge guide configuration that is used as an amplifier to amplify an input signal 611 (illustrated as a dashed arrow) to provide an amplified signal 612 (illustrated as a dashed arrow). Figure 6B is a simplified, enlarged, top view of an active region 638 of the amplifier 614 of Figure 6A. For example, the amplifier 614 of Figure 6A can be used in the laser assembly 510 of Figure 5, or in another type of system.

In this design, the gain medium 614 can be similar to the design described above in reference to Figures 1A-1E. In this design, the gain medium 614 includes (i) a first end section 624 having a first end width 624b; (ii) a first tapered section 626 having a first tapered width 626b; (iii) a central section 628 having a central width 628b; (iv) a second tapered section 630 having a second tapered width 630b; and (v) a second end section 632 having a second end width 632b that are similar to the corresponding sections described above. More specifically, in this design, (i) the end sections 624, 632 are relatively narrow; (ii) the central section 628 is relatively wide; (iii) the end sections 624, 632 are narrower than the central section 628; (iv) the first tapered section 626 connects the first end section 624 to the central section 628; and (v) the second tapered section 630 connects the central section 628 to the second end section 632.

In certain implementations, the gain medium 614 has an anti-reflection coating on both facets 620a, 622a so that the input signal 611 easily enters the second facet 622a, and the amplified signal 612 easily exits the first facet 620a.

With the amplifier designs provided herein, (i) the central section 628 can be sized to support multiple spatial modes; (ii) the narrow, end sections 624, 632 can be sized to support a single spatial mode; and (ii) the tapered sections 626, 620 are sized and shaped to act as mode strippers that eliminate higher order guided modes generated by the central section 628. With this design, the gain medium 614 utilizes the wide central section 628 (with larger active region) to generate higher amplification, and the tapered sections 626, 630 to direct the light to the narrow, end sections 624, 632 that support only one guided optical mode. As a result, the gain medium 614 generates higher power, without degradation in beam quality.

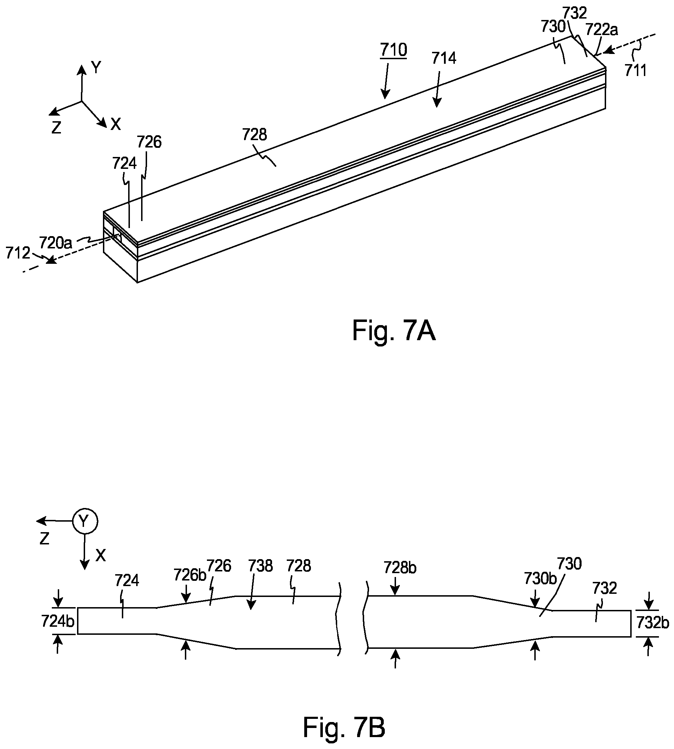

Figure 7A is a simplified perspective view of a gain medium 714 having a ridge guide configuration that is used as an amplifier to amplify an input signal 711 (illustrated as a dashed arrow) to provide an amplified signal 712 (illustrated as a dashed arrow). Figure 7B is a simplified, enlarged, top view of an active region 738 of the amplifier 714 of Figure 7A. For example, the amplifier 714 of Figure 7A can be used in the laser assembly 510 of Figure 5, or in another type of system.

In this design, the gain medium 714 can be similar to the design described above in reference to Figures 3A-3D or Figures 8A-8D below. In this design, the gain medium 714 includes (i) a first end section 724 having a first end width 724b; (ii) a first tapered section 726 having a first tapered width 726b; (iii) a central section 728 having a central width 728b; (iv) a second tapered section 730 having a second tapered width 730b; and (v) a second end section 732 having a second end width 732b that are similar to the corresponding sections described above. More specifically, in this design, (i) the end sections 724, 732 are relatively narrow; (ii) the central section 728 is relatively wide; (iii) the end sections 724, 732 are narrower than the central section 728; (iv) the first tapered section 726 connects the first end section 724 to the central section 728; and (v) the second tapered section 730 connects the central section 728 to the second end section 732.

In certain implementations, the gain medium 714 has an anti-reflection coating on both facets 720a, 722a so that the input signal 711 easily enters the second facet 722a, and the amplified signal 712 easily exits the first facet 720a.

Figure 8A is a simplified, perspective view of yet another laser assembly 810 that generates a laser beam 812 that includes a gain medium 814, a power supply 816, and a system controller 818. In this design, the power supply 816, and the system controller 818 are similar to the corresponding components described above in reference to Figures 3A-3D. However, in this implementation, the gain medium 814 has a slightly different buried heterostructure. It should be noted that the buried heterostructure of the gain medium 814 of Figure 8A, is just another, non-exclusive example of a two-step regrowth design, and that other configurations of the buried heterostructure of the gain medium are possible.

Similar to implementation illustrated in Figures 3A-3D, the gain medium 814 of Figure 8A can be designed to include five sections that are designated as (i) a first end section 824 that includes the first facet 820a; (ii) a first tapered section 826; (iii) a central section 828; (iv) a second tapered section 830; and (vi) a second end section 824 that includes the second facet 822a. The design of each of those sections 824, 826, 828, 830, 832 can be somewhat similar to the corresponding components described above and illustrated in Figures 3A-3D.

Alternatively, for example, the gain medium 814 of Figure 8A can be designed to include only three sections similar to the design described above and illustrated in Figures 2A and 2B.

Figure 8B is a simplified cut-away of the central section 828 of the gain medium 814 taken on line 8B-8B in Figure 8A near the center of the gain medium 814 that illustrates the central dimension 828b. Figure 8C is a simplified cut-away view of the first tapered section 826 of the gain medium 814 taken on line 8C-8C in Figure 8A that illustrates the first tapered dimension 826b. Further, Figure 8D is a simplified cut-away view of the first end section 824 of the gain medium 814 taken on line 8D-8D in Figure 8A that illustrates the first end dimension 824b. These Figures illustrate the buried heterostructure of the gain medium 814, as well as the varying width of the gain medium 814.

With reference to Figures 8A-8D, the gain medium 814 includes a plurality of layers, namely (i) a substrate layer 834, (ii) a first cladding layer 836, (iii) a core layer 838, (iv) a second cladding layer 840, (v) a current blocking layer 842, and (vi) a conductive layer 844. The thickness and shape of these layers can be varied to suit the design of the gain medium 814. Further, one or more of the layers can have a different configuration than is illustrated in Figures 8A-8D.

In the implementation of Figures 8A-8D, the layers 884, 836, 838, 840, 842, 844 can be similar to the corresponding components described above and illustrated Figures 3A-3D. However, in Figures 8A-8D, the shape of the second cladding layer 840 and the current blocking layer 842 are slightly different. More specifically, in this design, the second cladding layer 840 is not as wide, and the current blocking layer 842 extends from the first cladding layer 836 to the conductive layer 844.

In Figures 8A-8D, (i) the first cladding layer 836 is positioned between the substrate layer 834 and the core layer 838, (ii) the core layer 838 is positioned between the cladding layers 836, 840, (iii) the current blocking layer 842 is positioned on the sides of the core layer 838 and the second cladding layer 840, and (iv) the conductive layer 844 is positioned over the second cladding layer 840 and the current blocking layer 842.

While the particular designs as shown and disclosed herein are fully capable of obtaining the objects and providing the advantages herein before stated, it is to be understood that they are merely illustrative of the presently preferred embodiments of the invention and that no limitations are intended to the details of construction or design herein shown other than as described in the appended claims.

**Claims**

1. A gain medium (14) that amplifies a signal (514a) when sufficiently powered, the gain medium comprising:

   a substrate (34); and
   an active region (38) coupled to the substrate, the active region amplifying the signal when sufficient power is directed to the active region, the active region including (i) a central section having a central dimension along a first axis that is substantially constant along the central section (28); (ii) a first end section (24) having a first end dimension along the first axis that is substantially constant along the first end section, the first end dimension being smaller than the central dimension; and (iii) a first tapered section (26) that connects the first end section to the central section, wherein the first tapered section has a first tapered dimension along the first axis that tapers from the central section to the first end section;
   wherein a transition (33) between the first end section and the first tapered section is curved to aid adiabatic transition and reduce reflections; and
   wherein the active region is a quantum cascade active region.

2. The gain medium of claim 1 wherein the first end section includes a first facet (20a), and wherein the active region emits light from the first facet.

3. The gain medium of any one of claims 1 or 2 wherein the first tapered section has an adiabatic taper.

4. The gain medium of any one of claims 1 to 3 wherein the first tapered section has a tapered length of at least seven microns.

5. The gain medium of any one of claims 1 to 4 further comprising (i) a second end section (32) having a second end dimension along the first axis that is substantially constant along the second end section, the second end dimension being smaller than the central dimension; and (ii) a second tapered section (30) that connects the second end section to the central section, wherein the second tapered section has a second tapered dimension along the first axis that tapers from the central section to the second end section.

6. The gain medium of claim 5 wherein the second end dimension is approximately equal to the first end dimension.

7. The gain medium of claim 2 and any one of claims 5 or 6 wherein the second end section includes a second facet (22a) that is spaced apart from the first facet, and wherein the active region also emits light from the second facet

8. The gain medium of claim 2 and any one of claims 5 or 6 wherein the second end section includes a second facet (22a) that is spaced apart from the first facet and wherein the active region only emits light from the first facet.

9. A method for making an amplifier for amplifying a signal (514a) comprising:

   providing a substrate (34); and
   growing and patterning an active region (38) on the substrate that amplifies the signal when sufficient power is directed to the active region, the active region including (i) a central section (28) having a central dimension along a first axis that is substantially constant along the central section; (ii) a first end section (24) having a first end dimension along the first axis that is substantially constant along the first end section, the first end dimension being smaller than the central dimension; and (iii) a first tapered section (26) that connects the first end section to the central section, wherein the first tapered section has a first tapered dimension along the first axis that tapers from the central section to the first end section;
   wherein a transition (33) between the first end section and the first tapered section is curved to aid adiabatic transition and reduce reflections; and
wherein the active region is a quantum cascade active region.

**Patentansprüche**

1. Verstärkungsmedium (14), das ein Signal (514a) verstärkt, wenn ausreichend mit Energie versorgt, wobei das Verstärkungsmedium aufweist:

   ein Substrat (34); und
   einen aktiven Bereich (38), der mit dem Substrat gekoppelt ist, wobei der aktive Bereich das Signal verstärkt, wenn ausreichend Energie an den aktiven Bereich zugeführt wird, wobei der aktive Bereich weist (i) einen mittleren Abschnitt mit einer mittleren Abmessung entlang einer ersten Achse, die entlang des mittleren Abschnitts (28) im Wesentlichen konstant ist; (ii) einen ersten Endabschnitt (24) mit einer ersten Endabmessung entlang der ersten Achse, die entlang des ersten Endabschnitts im Wesentlichen konstant ist, wobei die erste Endabmessung kleiner als die mittlere Abmessung ist; und (iii) einen ersten sich verjüngenden Abschnitt (26), der den ersten Endabschnitt mit dem mittleren Abschnitt verbindet, wobei der erste sich verjüngende Abschnitt eine erste sich verjüngende Abmessung entlang der ersten Achse aufweist, die sich vom mittleren Abschnitt zum ersten Endabschnitt verjüngt, auf;
   wobei ein Übergang (33) zwischen dem ersten Endabschnitt und dem ersten sich verjüngenden Abschnitt gekrümmt ist, um einen adiabatischen Übergang zu unterstützen und Reflexionen zu reduzieren; und
   wobei der aktive Bereich ein aktiver Bereich einer Quantenkaskade ist.

2. Verstärkungsmedium nach Anspruch 1, wobei der erste Endabschnitt eine erste Facette (20a) aufweist und wobei der aktive Bereich Licht von der ersten Facette emittiert.

3. Verstärkungsmedium nach einem der Ansprüche 1 oder 2, wobei der erste sich verjüngender Abschnitt eine adiabatische Verjüngung aufweist.

4. Verstärkungsmedium nach einem der Ansprüche 1 bis 3, wobei der erste sich verjüngende Abschnitt eine sich verjüngende Länge von mindestens sieben Mikrometern aufweist.

5. Verstärkungsmedium nach einem der Ansprüche 1 bis 4, ferner aufweisend (i) einen zweiten Endabschnitt (32) mit einer zweiten Endabmessung entlang der ersten Achse, die entlang des zweiten Endabschnitts im Wesentlichen konstant ist, wobei die zweite Endabmessung kleiner ist als die mittlere Abmessung; und (ii) einen zweiten sich verjüngenden Abschnitt (30), der den zweiten Endabschnitt mit dem mittleren Abschnitt verbindet, wobei der zweite sich verjüngende Abschnitt eine zweite sich verjüngende Abmessung entlang der ersten Achse aufweist, die sich vom mittleren Abschnitt zum zweiten Endabschnitt verjüngt.

6. Verstärkungsmedium nach Anspruch 5, wobei die zweite Endabmessung ungefähr gleich der ersten Endabmessung ist.

7. Verstärkungsmedium nach Anspruch 2 und einem der Ansprüche 5 oder 6, wobei der zweite Endabschnitt eine zweite Facette (22a) aufweist, die von der ersten Facette beabstandet ist, und wobei der aktive Bereich auch Licht von der zweiten Facette emittiert.

8. Verstärkungsmedium nach Anspruch 2 und einem der Ansprüche 5 oder 6, wobei der zweite Endabschnitt eine zweite Facette (22a) aufweist, die von der ersten Facette beabstandet ist, und wobei der aktive Bereich nur Licht von der ersten Facette emittiert.

9. Verfahren zum Herstellen eines Verstärkers zum Verstärken eines Signals (514a), aufweisend:

   Bereitstellen eines Substrats (34); und
   Aufwachsen und Strukturieren eines aktiven Bereichs (38) auf dem Substrat, der das Signal verstärkt, wenn ausreichend Energie in den aktiven Bereich zugeführt wird, wobei der aktive Bereich aufweist: (i) einen mittleren Abschnitt (28) mit einer mittleren Abmessung entlang einer ersten Achse, die entlang des mittleren Abschnitts im Wesentlichen konstant ist; (ii) einen ersten Endabschnitt (24) mit einer ersten Endabmessung entlang der ersten Achse, die entlang des ersten Endabschnitts im Wesentlichen konstant ist, wobei die erste Endabmessung kleiner ist als die mittlere Abmessung; und (iii) einen ersten sich verjüngenden Abschnitt (26), der den ersten Endabschnitt mit dem mittleren Abschnitt verbindet, wobei der erste sich verjüngende Abschnitt eine erste sich verjüngende Abmessung entlang der ersten Achse aufweist, die sich vom mittleren Abschnitt zum ersten Endabschnitt verjüngt;

wobei ein Übergang (33) zwischen dem ersten Endabschnitt und dem ersten sich verjüngenden Abschnitt gekrümmt ist, um einen adiabatischen Übergang zu unterstützen und Reflexionen zu reduzieren; und

wobei der aktive Bereich ein aktiver Bereich einer Quantenkaskade ist.

**Revendications**

1.  Milieu amplificateur (14) qui amplifie un signal (514a) lorsqu'il est suffisamment alimenté, le milieu amplificateur comprenant :

    un substrat (34) ; et
    une région active (38) couplée au substrat, la région active amplifiant le signal lorsqu'une puissance suffisante est dirigée vers la région active, la région active comprenant (i) une section centrale ayant une dimension centrale le long d'un premier axe qui est sensiblement constante le long de la section centrale (28) ; (ii) une première section d'extrémité (24) ayant une première dimension d'extrémité le long du premier axe qui est sensiblement constante le long de la première section d'extrémité, la première dimension d'extrémité étant plus petite que la dimension centrale ; et (iii) une première section effilée (26) qui relie la première section d'extrémité à la section centrale, dans lequel la première section effilée a une première dimension effilée le long du premier axe qui s'effile de la section centrale à la première section d'extrémité ;
    dans lequel une transition (33) entre la première section d'extrémité et la première section effilée est courbée pour faciliter la transition adiabatique et réduire les réflexions ; et
    dans lequel la région active est une région active de cascade quantique.

2.  Milieu amplificateur selon la revendication 1, dans lequel la première section d'extrémité comprend une première facette (20a), et dans lequel la région active émet de la lumière à partir de la première facette.

3.  Milieu amplificateur selon l'une quelconque des revendications 1 ou 2, dans lequel la première section effilée présente un effilement adiabatique.

4.  Milieu de gain selon l'une quelconque des revendications 1 à 3, dans lequel la première section effilée a une longueur effilée d'au moins sept microns.

5.  Milieu de gain selon l'une quelconque des revendications 1 à 4, comprenant en outre (i) une deuxième section d'extrémité (32) ayant une deuxième dimension d'extrémité le long du premier axe qui est sensiblement constante le long de la deuxième section d'extrémité, la deuxième dimension d'extrémité étant plus petite que la dimension centrale ; et (ii) une deuxième section effilée (30) qui relie la deuxième section d'extrémité à la section centrale, dans lequel la deuxième section effilée a une deuxième dimension effilée le long du premier axe qui s'effile de la section centrale à la deuxième section d'extrémité.

6.  Milieu amplificateur selon la revendication 5, dans lequel la deuxième dimension d'extrémité est approximativement égale à la première dimension d'extrémité.

7.  Milieu amplificateur selon la revendication 2 et l'une quelconque des revendications 5 ou 6, dans lequel la deuxième section d'extrémité comprend une deuxième facette (22a) qui est espacée de la première facette, et dans lequel la région active également émet de la lumière à partir de la deuxième facette.

8.  Milieu de gain selon la revendication 2 et l'une quelconque des revendications 5 ou 6, dans lequel la deuxième section d'extrémité comprend une deuxième facette (22a) qui est espacée de la première facette et dans lequel la région active n'émet de la lumière qu'à partir de la première facette.

9.  Procédé de fabrication d'un amplificateur pour amplifier un signal (514a), comprenant :

    la fourniture d'un substrat (34) ; et
    la croissance et la structuration d'une région active (38) sur le substrat qui amplifie le signal lorsqu'une puissance suffisante est dirigée vers la région active, la région active comprenant (i) une section centrale (28) ayant une dimension centrale le long d'un premier axe qui est sensiblement constante le long de la section centrale ; (ii) une première section d'extrémité (24) ayant une première dimension d'extrémité le long du premier axe qui est sensiblement constante le long de la première section d'extrémité, la première dimension d'extrémité étant plus petite que la dimension centrale ; et (iii) une première section effilée (26) qui relie la première section d'extrémité à la section centrale, dans lequel la première section effilée a une première dimension effilée le long du premier axe qui s'effile de la section centrale à la première section d'extrémité ;

dans lequel une transition (33) entre la première section d'extrémité et la première section effilée est courbée pour faciliter la transition adiabatique et réduire les réflexions ; et

dans lequel la région active est une région active de cascade quantique.

Fig. 1A

Fig. 1B

Fig. 1C

Fig. 1D

Fig. 1E

Fig. 2A

Fig. 2B

Fig. 3A

Fig. 3B

Fig. 3C

Fig. 3D

# Fig. 4

# Fig. 5

Fig. 6A

Fig. 6B

Fig. 7A

Fig. 7B

Fig. 8A

Fig. 8B

Fig. 8C

Fig. 8D

**REFERENCES CITED IN THE DESCRIPTION**

**Patent documents cited in the description**

- US 2022320826 A1
- US 2021013701 A1
- US 2003112842 A1
- US 2014064311 A1
- US 2015311676 A1
- US 8811447 B2
- US 4689797 A

**Non-patent literature cited in the description**

- **SIGOGNE, D. et al.** 1.55 MUM POLARISATION INSENSITIVE INGAASP STRAINED MQW OPTICAL AMPLIFIER INTEGRATED WITH SHORT SPOT-SIZE ADD. CONVERTERS. *ELECTRONICS LETTERS, THE INSTITUTION OF ENGINEERING AND TECHNOLOGY*, 18 July 1996, vol. 32 (15), 1403-1405